# EUROPÄISCHE PATENTANMELDUNG

(11) **EP 4 716 449 A1**
(43) Veröffentlichungstag der Anmeldung: **25.03.2026**
(21) Anmeldenummer: 25202599.4
(22) Anmeldetag: 16.09.2025
(51) Int. Cl.: H10W 70/65, H10W 90/10, H10W 70/00, H10W 74/10, H02M 7/00, H10W 70/60

(54) **LEISTUNGSMODUL, BAUGRUPPE UND VERFAHREN ZUR BEFESTIGUNG VON STEUERPINS**

(30) Priorität: 24.09.2024 DE 102024209133
(71) Anmelder: VOLKSWAGEN AG, 38440 Wolfsburg (DE)
(72) Erfinder: Bayer, Dr. Christoph Friedrich, 38440 Wolfsburg (DE); Michelsen, Steffen, 38440 Wolfsburg (DE); Pieper, Dr. Sven, 38440 Wolfsburg (DE); Tegethoff, Thomas, 38440 Wolfsburg (DE); Zimmermann, Matthias, 38440 Wolfsburg (DE); Lieker, Stephan, 38440 Wolfsburg (DE); Kramm, Michael, 38440 Wolfsburg (DE)

(57) **Zusammenfassung**

Die Erfindung betrifft ein Leistungsmodul (1), umfassend einen Träger (2) mit einer strukturierten Metallisierung (3), wobei auf der Metallisierung (3) mindestens ein Leistungshalbleiter (4) angeordnet ist und die Metallisierung (3) mindestens eine Kontaktfläche (7) für einen Steuerpin (13) aufweist, wobei das Leistungsmodul (1) mit einer Vergussmasse (9) vergossen ist, wobei auf der mindestens einen Kontaktfläche (7) für den Steuerpin (13) ein Sockelelement (5) angeordnet ist, das elektrisch mit der Kontaktfläche (7) verbunden ist, wobei mindestens eine Oberseite (10) des Sockelelements (5) nicht von der Vergussmasse (9) bedeckt ist, wobei die Oberseite (10) eine geschlossene Fläche aufweist, die ein Vielfaches größer als eine Kontaktfläche des Steuerpins (13) ist, eine Baugruppe (11) und ein Verfahren zum Befestigen von Steuerpins (13).

## Beschreibung

Die Erfindung betrifft ein Leistungsmodul, eine Baugruppe mit mindestens zwei Leistungsmodulen und ein Verfahren zur Befestigung von Steuerpins auf einer solchen Baugruppe.

Leistungsmodule werden häufig in Wechselrichtern, DC/DC-Wandlern oder anderen Schaltteilen verwendet. Die Leistungsmodule weisen mindestens einen Leistungshalbleiter auf, der beispielsweise als IGBT, MOSFET oder GaN HEM ausgebildet ist. Typischerweise weist ein Leistungsmodul mehrere Leistungshalbleiter auf. Dabei sind die Leistungshalbleiter auf einem Träger mit einer strukturierten Metallisierung angeordnet. Der Träger ist beispielsweise eine elektrisch isolierende, aber thermisch gut leitfähige Keramik. Bekannte Technologien sind beispielsweise IMS (Isolated Metal Substrate) oder DCB (Direct Copper Bording). Dabei findet ein Teil der Kontaktierung der Leistungshalbleiter untereinander über die Metallisierung statt. Eine externe Spannung wird über großflächige Kontakte zugeführt, die beispielsweise als Leadframes ausgebildet sind. Ebenso werden die Ausgangsanschlüsse als großflächige Kontakte herausgeführt. Zur Zuführung von Steuersignalen für die Steuerelektroden (Gates) oder zum Erfassen von Messsignalen (z.B. der Temperatur über ein Kelvin-Source-Kontakt) dienen Steuerpins, die typischerweise auf Kontaktflächen der Metallisierung angeordnet sind und senkrecht nach oben geführt sind (d.h. diese sind parallel zu einer Flächennormalen des Trägers).

Dabei ist es weiter bekannt, dass die Leistungsmodule zum Schutz vergossen werden. Mehrere solcher Leistungsmodule können dann auf einem gemeinsamen Träger (z.B. einem Kühlkörper) angeordnet werden.

Dabei ist es bekannt, die Steuerpins erst nach dem Vergießen mit dem Leistungsmodul zu verbinden. Hierzu werden Pin-Hülsen auf der entsprechenden Kontaktfläche der Metallisierung angeordnet. Dabei wird die Oberfläche der hohlzylindrischen Pin-Hülsen nicht vergossen, sodass nach dem Vergießen die Steuerpins in die Pin-Hülsen gesteckt werden können.

Derartige Pin-Hülsen sind beispielsweise in der CN 115274472 A beschrieben.

Der Erfindung liegt das technische Problem zugrunde, ein Leistungsmodul zu schaffen, bei dem die Kontaktierung eines Steuerpins verbessert ist. Ein weiteres technisches Problem ist die Schaffung einer Baugruppe mit mehreren Leistungsmodulen sowie ein Verfahren zur Befestigung von Steuerpins zur Verfügung zu stellen.

Die Lösung des technischen Problems ergibt sich durch ein Leistungsmodul mit den Merkmalen des Anspruchs 1, eine Baugruppe mit den Merkmalen des Anspruchs 8 sowie ein Verfahren mit den Merkmalen des Anspruchs 9. Weitere vorteilhafte Ausgestaltungen der Erfindung ergeben sich aus den Unteransprüchen.

Das Leistungsmodul umfasst einen Träger mit einer strukturierten Metallisierung, wobei auf der Metallisierung mindestens ein Leistungshalbleiter angeordnet ist und die Metallisierung mindestens eine Kontaktfläche für einen Steuerpin aufweist, wobei das Leistungsmodul mit einer Vergussmasse vergossen ist. Dabei ist auf der mindestens einen Kontaktfläche für den Steuerpin ein Sockelelement angeordnet, das elektrisch mit der Kontaktfläche verbunden ist, wobei mindestens eine Oberseite des Sockelelements nicht von der Vergussmasse bedeckt ist. Dabei weist die Oberseite des Sockelelements eine geschlossene Fläche auf, die ein Vielfaches größer als eine Kontaktfläche des Steuerpins ist. Hierdurch besteht eine größere Flexibilität zur Anordnung der Steuerpins auf den Sockelelementen, sodass entstehende geometrische Versätze ausgeglichen werden, insbesondere wenn zwei oder mehr Leistungsmodule zu einer Baugruppe auf einem gemeinsamen Träger, wie beispielsweise einem Kühlkörper, angeordnet werden. Ein weiterer Vorteil der geschlossenen Oberfläche ist, dass die Anforderungen beim Vergießen entschärft sind, im Gegensatz zum Stand der Technik, wo stets sichergestellt werden muss, dass keine Vergussmasse in die offene Pin-Hülse fließt.

In einer Ausführungsform ist das mindestens eine Sockelelement rotationssymmetrisch ausgebildet, wobei weiter vorzugsweise die Oberseite eine Kreisfläche ist.

In einer weiteren Ausführungsform ist das Sockelelement ein Zylinder oder Kegelstumpf, wobei beim Kegelstumpf die größere Seite die Oberseite bildet.

In einer weiteren Ausführungsform ist das Sockelelement hantelförmig ausgebildet und setzt sich aus drei Zylindern zusammen, wobei der mittlere Zylinder einen kleineren Durchmesser aufweist. Der Vorteil ist, dass das Sockelelement besser von der Vergussmasse umgeben ist. In einer weiteren Ausführungsform weist das Sockelelement zusätzlich einen umlaufenden Ring auf. Dieser Ring dient als Auflagefläche für eine Sonotrode, um das Sockelelement mittels Reibschweißen auf der Kontaktfläche zu befestigen.

In einer weiteren Ausführungsform ist das Sockelelement als Hohlkörper ausgebildet, sodass Material gespart werden kann, wobei die Erhöhung des Widerstandes vernachlässigbar ist.

In einer weiteren Ausführungsform ist auf der Oberfläche des Sockelelements eine Pin-Hülse angeordnet. Vorzugsweise wird die Pin-Hülse nach dem Vergießen auf die Oberfläche aufgebracht. Der Vorteil ist, dass dann auf die bekannten Verfahren zum Einfügen der Steuerpins in eine Pin-Hülse zurückgegriffen werden kann. Die Pin-Hülse ist dann nur kürzer als im Stand der Technik.

Die erfindungsgemäße Baugruppe umfasst mindestens zwei zuvor beschriebene Leistungsmodule, die auf einem gemeinsamen Träger angeordnet sind, wobei der Träger vorzugsweise ein Kühlkörper ist.

Das Verfahren zur Befestigung von Steuerpins auf einer Baugruppe erfolgt dadurch, dass den einzelnen Steuerpins geometrische Positionen in Bezug auf den gemeinsamen Träger zugeordnet sind. Dies sind quasi die Soll-Positionen, die die Steuerpins haben sollten, damit diese zu einer Leiterplatte korrespondieren, auf der beispielsweise die Gate-Treiber angeordnet sind. Über eine entsprechende Positionseinrichtung können dann die Steuerpins zu den ihnen zugeordneten Sockelelementen positioniert und befestigt werden. Aufgrund der vergrößerten Oberfläche der Sockelelemente können nun Lageabweichungen der Leistungsmodule auf dem Träger ausgeglichen werden, beispielsweise wenn die Leistungsmodule nicht exakt parallel zu einer Kante des Trägers ausgerichtet sind.

Die Erfindung wird nachfolgend anhand bevorzugter Ausführungsbeispiele näher erläutert. Die Figuren zeigen:
- Fig. 1: eine schematische Darstellung eines Leistungsmoduls vor dem Vergießen mit einer Vergussmasse,
- Fig. 2: eine schematische Darstellung eines Leistungsmoduls nach dem Vergießen,
- Fig. 3: eine schematische Darstellung einer Baugruppe mit drei Leistungsmodulen,
- Fig. 4: eine schematische Darstellung einer Baugruppe mit Steuerpins,
- Fig. 5: ein hantelförmiges Sockelelement und
- Fig. 6: ein Sockelelement mit einem umlaufenden Ring.

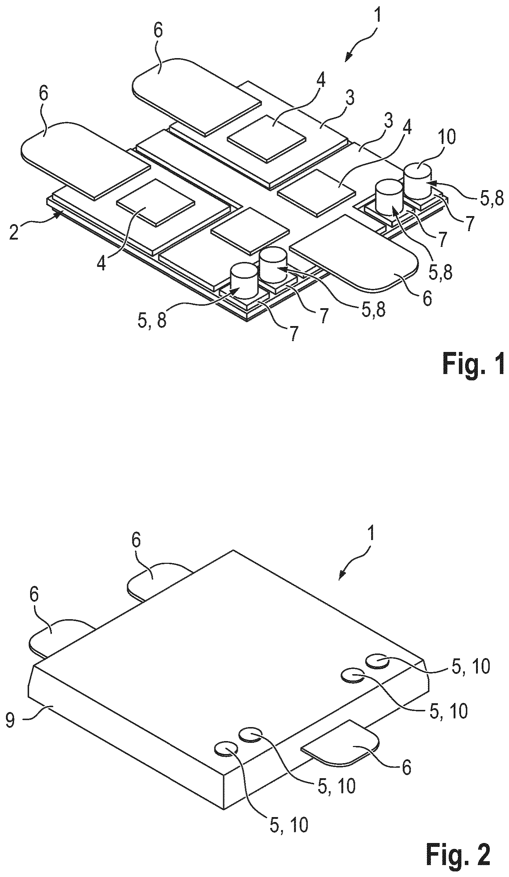

In der Fig. 1 ist stark vereinfacht ein Leistungsmodul 1 vor dem Verguss mit einer Vergussmasse dargestellt. Das Leistungsmodul 1 weist einen Träger 2 auf, auf dem eine strukturierte Metallisierung 3 aufgebracht ist. Typischerweise ist auch auf der Unterseite des Trägers eine Metallisierung aufgebracht. Der Träger 2 ist beispielsweise eine Keramik. Auf der strukturierten Metallisierung 3 sind vier Leistungshalbleiter 4, vier Sockelelemente 5 und drei Anschlusskontakte 6 in der Form von Leadframes angeordnet. Die vier Leistungshalbleiter 4 sind beispielsweise als MOSFETs ausgebildet, die beispielsweise eine Halbbrücke bilden. Hierzu sind jeweils zwei Leistungshalbleiter parallel geschaltet und die beiden Parallelschaltungen in Reihe geschaltet. Über die beiden oberen Anschlusskontakte 6 wird dann HV+ und HV- zugeführt, wobei der untere Anschlusskontakt 6 den Mittelabgriff der Halbbrücke herausführt. Die Sockelelemente 5 sind mit Gate-Kontakten der Leistungshalbleiter 4 verbunden und auf Kontaktflächen 7 der strukturierten Metallisierung 3 angeordnet. Beispielsweise sind die Sockelelemente 5 mit der Kontaktfläche 7 verlötet oder verschweißt. Die Sockelelemente sind als Zylinder 8 ausgebildet.

In der Fig. 2 ist das Leistungsmodul 1 nach Verguss mit einer Vergussmasse 9 dargestellt, wobei die Anschlusskontakte 6 und eine Oberseite 10 der Sockelelemente 5 frei zugänglich bleiben. Ebenfalls bleibt eine an der Unterseite des Trägers 2 aufgebrachte Metallisierung von der Vergussmasse 9 unbedeckt.

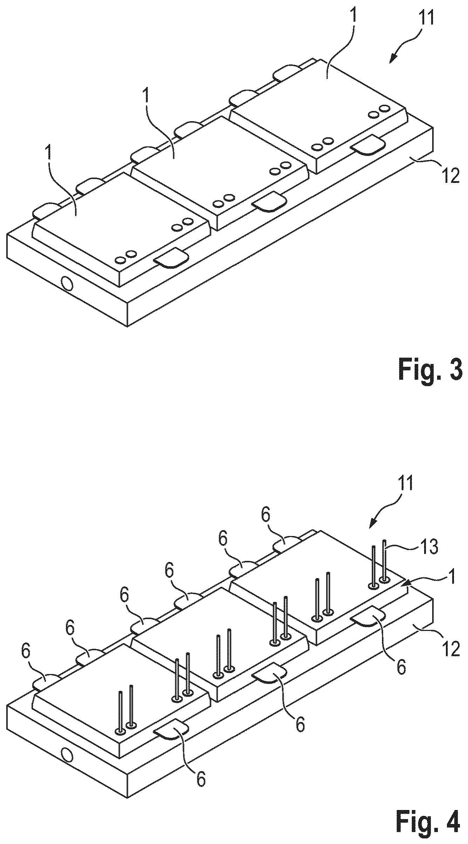

In der Fig. 3 ist eine Baugruppe 11 dargestellt, die aus drei Leistungsmodulen 1 gemäß Fig. 2 besteht, die auf einem gemeinsamen Träger 12 angeordnet sind. Beispielsweise sind die Leistungsmodule 1 aufgelötet oder aufgesintert. Dabei kann es zu einem geometrischen Versatz der Leistungsmodule 1 zueinander kommen. Allerdings sind die Sollpositionen von Steuerpins 13 bekannt, die diese aufweisen sollten, damit diese mit einer nicht dargestellten Leiterplatte verbunden werden können. Da die Oberseite 10 der Sockelelemente 5 erheblich größer als die Kontaktfläche der Steuerpins 13 ist, können diese nun so auf den Oberseiten 10 der Sockelelemente 5 angeordnet werden, dass diese an ihren Sollpositionen sich befinden, was in Fig. 4 dargestellt ist. D.h. trotz geometrischen Versatzes der Leistungsmodule 1 befinden sich alle Steuerpins 13 an einer Position, als wären die Leistungsmodule 1 richtig ausgerichtet. Sollten die Leistungsmodule 1 richtig ausgerichtet sein, so wären alle Steuerpins 13 im Kreismittelpunkt der Oberseite 10 der Sockelelemente 5 angeordnet.

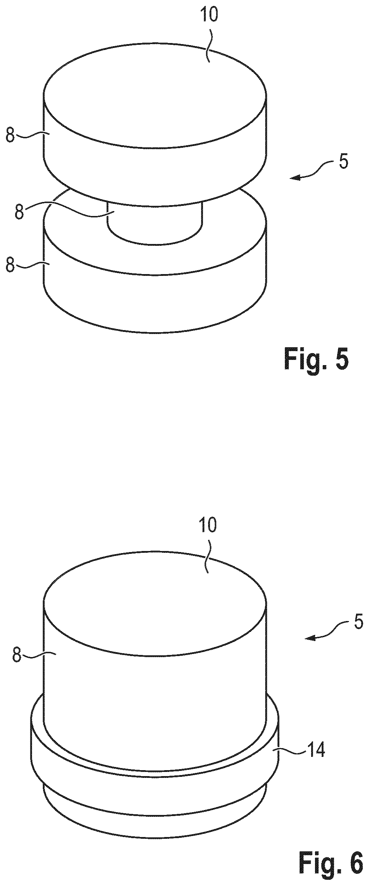

In der Fig. 5 ist eine alternative Ausführungsform für ein Sockelelement 5 dargestellt, das aus drei Zylindern 8 besteht, wobei der obere und untere Zylinder 8 vom Durchmesser größer sind. Dies stellt eine Hantelform dar.

In der Fig. 6 ist eine weitere alternative Ausführungsform eines Sockelelements 5 dargestellt, das als Zylinder 8 mit einem umlaufenden Ring 14 ausgebildet ist.

Allgemein können die Sockelelemente 5 aus Kupfer oder Aluminium bestehen. Auch können die Sockelelemente 5 jeweils als Voll- oder Hohlkörper ausgebildet sein.

### Bezugszeichenliste

- 1: Leistungsmodul
- 2: Träger
- 3: strukturierte Metallisierung
- 4: Leistungshalbleiter
- 5: Sockelelement
- 6: Anschlusskontakt
- 7: Kontaktfläche
- 8: Zylinder
- 9: Vergussmasse
- 10: Oberseite
- 11: Baugruppe
- 12: Träger
- 13: Steuerpin
- 14: umlaufender Ring

## Patentansprüche

1. Leistungsmodul (1), umfassend einen Träger (2) mit einer strukturierten Metallisierung (3), wobei auf der Metallisierung (3) mindestens ein Leistungshalbleiter (4) angeordnet ist und die Metallisierung (3) mindestens eine Kontaktfläche (7) für einen Steuerpin (13) aufweist, wobei das Leistungsmodul (1) mit einer Vergussmasse (9) vergossen ist,
**dadurch gekennzeichnet, dass**
auf der mindestens einen Kontaktfläche (7) für den Steuerpin (13) ein Sockelelement (5) angeordnet ist, das elektrisch mit der Kontaktfläche (7) verbunden ist, wobei mindestens eine Oberseite (10) des Sockelelements (5) nicht von der Vergussmasse (9) bedeckt ist, wobei die Oberseite (10) eine geschlossene Fläche aufweist, die ein Vielfaches größer als eine Kontaktfläche des Steuerpins (13) ist.

2. Leistungsmodul nach Anspruch 1, **dadurch gekennzeichnet, dass** das Sockelelement (5) rotationssymmetrisch ausgebildet ist.

3. Leistungsmodul nach Anspruch 2, **dadurch gekennzeichnet, dass** das Sockelelement (5) mindestens ein Zylinder (8) oder ein Kegelstumpf ist.

4. Leistungsmodul nach Anspruch 2 oder 3, **dadurch gekennzeichnet, dass** das Sockelelement (5) hantelförmig ausgebildet ist.

5. Leistungsmodul nach einem der Ansprüche 2 bis 4, **dadurch gekennzeichnet, dass** das Sockelelement (5) zusätzlich einen umlaufenden Ring (14) aufweist.

6. Leistungsmodul nach einem der vorangegangenen Ansprüche, **dadurch gekennzeichnet, dass** das Sockelelement (5) als Hohlkörper ausgebildet ist.

7. Leistungsmodul nach einem der vorangegangenen Ansprüche, **dadurch gekennzeichnet, dass** auf der Oberseite (10) des Sockelelements (5) eine Pin-Hülse angeordnet ist.

8. Baugruppe (11), umfassend mindestens zwei Leistungsmodule (1) nach einem der Ansprüche 1 bis 7, die auf einem gemeinsamen Träger (12) angeordnet sind.

9. Verfahren zur Befestigung von Steuerpins (13) auf einer Baugruppe (11) nach Anspruch 8, **dadurch gekennzeichnet, dass** den Steuerpins (13) geometrische Positionen in Bezug auf den gemeinsamen Träger (12) zugeordnet sind, wobei die Steuerpins (13) an den zugeordneten geometrischen Positionen auf den zugeordneten Sockelelementen (5) positioniert und befestigt werden.
